# EUROPEAN PATENT SPECIFICATION

(11) **EP 0 337 015 B1**
(45) Date of publication and mention of the grant of the patent: **04.08.1993**
(21) Application number: 88121447.2
(22) Date of filing: 22.12.1988
(51) Int. Cl.: C25D 5/12, H01L 23/06

(54) **Corrosion resistance enhancing electroplating process, and plated article**
Korrosionswiderstand verbesserndes Elektroplattierungsverfahren und elektroplattierter Gegenstand
Procédé d'électroplacage modifiant la résistance à la corrosion et article électroplaqué

(30) Priority: 21.01.1988 US 146350
(43) Date of publication of application: 18.10.1989
(73) Proprietor: ELECTRO-ALLOYS CORP., Elmsford New York 10523-1105 (US)
(72) Inventor: Levine, Samuel W., Dr., Roslyn, N. Y. 11576 (US)
(74) Representative: Rüger, Rudolf, Dr.-Ing.

(56) References cited:
- GB-A- 2 138 025
- US-A- 4 284 481
- US-A- 4 666 796
- CHEMICAL ABSTRACTS, vol. 103, no. 20, November 1985, page 557, abstract no. 168760s, Columbus, Ohio, US; & JP-A-60 114 591 (CITIZEN WATCH CO., LTD) 21-06-1985

## Description

The invention concerns a plated metal part and a process for producing the plated metal part.

Background. All exposed surfaces of parts of high reliability semiconductor packages must be highly resistant to salt and corrosive atmospheres. Frequently, the lid or cover of such packages is of metal. If appreciable corrosion occurs, the lid of the package will, in time, be penetrated and the package will lose its hermeticity. In addition, the corrosion will destroy the identification markings on the lid of the package.

The highest requirements for hermetically sealed packages, and testing methods, are described in the United States Government Military Standard MIL-STD 883C, Method 1009.4, Test Condition A. Plating of the metal parts of the package is governed by U.S. Military Standard MIL-M-38510G. This standard requires that a single layer of nickel of between 50 to 350 micro inches (1.27 to 8.89 micrometers) and a single layer of gold having a thickness of between 50 to 225 micro inches (1.27 micrometers to 5.72 micrometers) may be used. Alternatively, a multi-layer structure of pure nickel and pure gold may be used where the sum of the thicknesses of the nickel layers is between 50 and 350 microinches (1.27 to 8.89 micrometers) and the sum of the thicknesses of the gold layers is between 50 and 225 microinchcs (1.27 micrometers to 5.72 micrometers). The gold should have a purity of 99.7% or better.

Corrosion occurs on the metal parts because of defects in the nickel and gold layers of plating. The defects may be induced by imperfections in the base metal - either Alloy F15 (Kovar, trademark of Westinghouse Electric) or Alloy 42. Kovar is an alloy of about 17% cobalt, 29% nickel, the balance iron, and a minor percentage of other elements; Alloy 42 is about 42% nickel, the balance iron, and a minor percentage of other elements - all percentages by weight. This defect is usually caused by some type of contamination such as alumina embedded in the metal surface. It is characteristic of both thin layers of nickel and gold that they will not bridge over the contaminating particle. The imperfection may also come about from contamination particles existing in the plating solutions. These particles plate out with the nickel and gold layers and leave microscopic channels in the protective plating. A tiny channel in the nickel layer will not be bridged by the outside gold layer and thereby leave a microscopic hole extending to the surface of the base metal.

Indications of corrosion are visually detected by a deposit of iron oxide surrounding the defect hole. In the MIL-STD 883C salt atmosphere corrosion test, the chloride ion in the salt solution greatly accelerates the corrosion reaction. Since iron has a normal electrode potential of -0.440 volts in the electromotive series and gold has a normal electrode potential of +1.4 volts, diffusion of iron ions is accelerated to and through the gold layer where the iron oxide deposits around the hole in the gold layer. If the nickel layer had no defect in coincidence with the gold layer, corrosion would not take place.

Japanese patent application No. 60-11 4591 dicloses parts which can be used for watch bands and watch casings. The substrate of these metal parts comprise stainless steel which is to replace the formerly used brass substrate in order to obtain an article that suffers less from wearing than brass. The layers on the stainless steel substrate which is intrinsically corrosion-resistant are intended to give the article a more precious outfit, but they should not have an adverse effect on the resistivity against corrosion.

To obtain the first layer, the stainless steel is strike-plated with gold in a hydrochloric acid bath. Thereafter, the pretreated steel is plated with an Sn-Co alloy. After the plating with the tin alloy, a further strike-plating is used to obtain a thin gold layer on which a gold-nickel layer is deposited.

Watchbands and watch casings to not have to sustain a further heat treatment process, but the plating occurs after the article is completely machined.

US-A-4666 796 discloses plated metal parts which can be used as sealing lids for semiconductor packages. The known plated metal parts has an iron based alloy layer which is electroplated with a first layer of nickel. On the first layer of nickel a first layer of gold is electroplated. Then again a nickel layer is electroplated onto the first gold layer, and finally a second gold layer is electroplated on the second nickel layer so that the substrate is provided with four layers that are alternating nickel and gold. Among others the first nickel layer immediately upon the substrate surface is intended to act as a diffusion barrier which prevents the gold from diffusing into the substrate at the elevated temperatures when the sealing lid is bonded on its corresponding ceramic base plate.

GB-A-2138 025 discloses a silver-coated electrical material which exhibits a low-contact resistance even though it is exposed in an adverse atmosphere. The different layers of this arrangement are not provided for the purpose of protecting a substrate, since this substrate can be made of an electro-conductive or even a non-electro-conductive material which often is intrinsically protected against corrosion but to prevent the occurence of corrosive material at the outer surface of the contact. The first layer on the substrate is selected of Ni, Co, Cr or Pd. The first layer is covered by a second layer comprising one or more Sn, Cd, Pd, Ru or alloys thereof. The last layer is silver which has to make the electrical contact.

It is the object of the invention to provide a simplified plated metal part which is protected against corrosion and heat resistant such that it can be used as a semiconductor package sealing lid or cover. It is a further object of the invention to provide a process for producing the plated metal part.

Briefly, a metal article, such as a plate element suitable to form a semiconductor package lid, or a structure from which such package lids can be made, is plated by elecro plating only three layers on a substrate of metal, such as Alloy 42 or Kovar, namely a base layer, electroplated on the substrate, which base layer is formed by a metal which has an electromotive potential which is high with respect to the electromotive potential of the metal of the substrate. A single intermediate layer is then electroplated over the base layer. The single intermediate layer is formed by a metal which has an electromotive potential substantially lower than the electromotive potential of the metal of the base layer. A final, or cover layer is then electroplated on the intermediate layer. The cover layer is formed by a metal which has an electromotive potential which is high with respect to the intermediate layer, and preferably similar to that of the base layer.

A difference of electromotive potential of at least 1.2 volts between the electromotive potentials of the base layer and the intermediate layer is highly desirable to maintain some margin of safety between the electromotive potentials of the respective layers. Likewise, a difference of electromotive potential of at least 1.2 volts between the intermediate layer and the cover layer is desirable.

The substrate of the plated article includes nickel as a constituent component. Suitable materials for the base and cover layers then will be gold, with an electromotive potential of +1.4 v, platinum (+1.2 v), and silver (+0.8 v); examples of metals that may be used as the intermediate layer are nickel (-0.25 V) or a nickel based alloy. The aforementioned MIL-STD 883C requires gold for the cover layer and nickel for the intermediate layer so that difference between the electromotive potentials will be 1.65 V.

Other combinations are possible, for example silver (+0.8 V) and nickel (-0.25 v), resulting in a difference between the electromotive potentials of 1.05 V. For highest requirements and where the higher price of gold is justified, the three-layer system of gold-nickel-gold over the substrate is preferred.

Preferably, the intermediate layer has an electromotive potential which is at the negative side of the electromotive series of metals, and the base layer as well as the cover layer are identical, for example gold, and have high electromotive potentials at the positive end of the electromotive series of metals.

The suitability of plating only three layers on a substrate while meeting the required corrosion resistance, as exemplified by the military tests, has been recognized by the United States Defense Department. The previously effective military specifications for electroplating, MIL-M-38510G, was amended to a revised standard MIL-M-38510H. The amended Military Standard MIL-M-38510H states that in a multi-layer structure, it is acceptable to apply either nickel or gold to the base metal. The previous specification MIL-M-38510G did not permit the application of gold to the base metal directly, but required nickel as the first layer, resulting in four layers.

Superior corrosion resistance is achieved by applying gold on the base layer or substrate first, with the additional advantage of significantly reducing the complexity of the manufacturing process.

The three-layer system has an additional, entirely unexpected advantage, particularly when the base layer is gold and the article is made of an iron containing alloy, which has nickel as a constituent component, such as Alloy F15 or Alloy 42. One of the most severe production problems is to make such plated components which meet quality control tests referred to as heat blistering tests. When an article made as a semi-conductor package lid is heated, and the plating is not perfect, it has been found that some lots or parts develop blisters because, apparently, the plated layers do not properly adhere to each other or to the iron alloy substrate. Under stress, the blisters will peel off, and the peeled regions will present sites for severe corrosion. Parts which exhibit blistering are unacceptable and must be scrapped. A three-layer system in which gold is used as the base layer exhibited substantially batter adhesion to F15 or Alloy 42 substrates than other layers in which nickel is applied on the substrate. The three-layer system thus provides for superior adhesion of the plating on the substrate with significant reduction in blistering over prior art articles.

### Drawings:

Fig. 1 is a highly schematic fragmentary cross-sectional view through a semiconductor package cover lid, in which the dimensions of the substrates and the various lids are grossly distorted for clarity; and
Fig. 2 is a fragmentary cross-sectional view through a portion of the cover lid of Fig. 1, to an enlarged scale, and illustrating a defect.

The normal electrode potentials of the electromotive series is reproduced as Table 1.

**Table 1**

| ELECTROMOTIVE SERIES | |
|---|---|
| METAL | NORMAL ELECTRODE POTENTIAL* (Volts) |
| Gold | +1.4 |
| Platinum | +1.2 |
| Iridium | +1.0 |
| Palladium | +0.83 |
| Silver | +0.8 |
| Mercury | +0.799 |
| Osmium | +0.7 |
| Ruthenium | +0.45 |
| Copper | +0.344 |
| Bismuth | +0.20 |
| Antimony | +0.1 |
| Tungsten | +0.05 |
| Hydrogen | +0.000 |
| Lead | -0.126 |
| Tin | 0.136 |
| Molybdenum | -0.2 |
| Nickel | -0.25 |
| Cobalt | -0.28 |
| Indium | -0.3 |
| Cadmium | -0.402 |
| Iron | -0.440 |
| Chromium | -0.56 |
| Zinc | -0.762 |
| Niobium | -1.1 |
| Manganese | -1.05 |
| Vanadium | -1.5 |
| Aluminum | -1.67 |
| Beryllium | -1.70 |
| Titanium | -1.75 |
| Magnesium | -2.38 |
| Calcium | -2.8 |
| Strontium | -2.89 |
| Barium | -2.90 |
| Potassium | -2.92 |

| | |
|---|---|
| *The potential of the metal is with respect to the most reduced state except with copper and gold where the cupric (Cu⁺⁺) and auric (Au⁺⁺⁺) ions are usually more stable. | |

### Detailed Description.

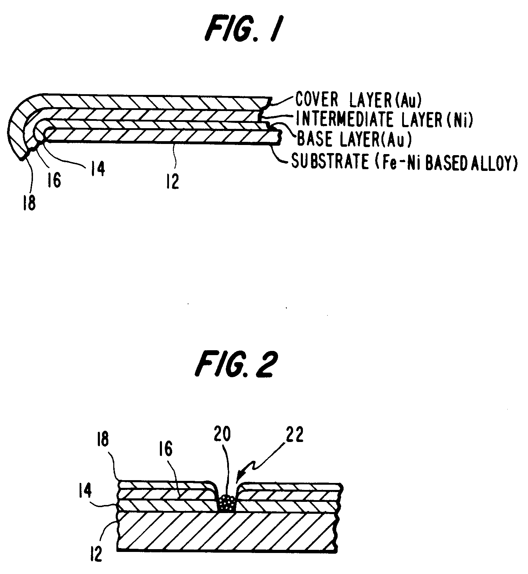

A substrate 12 of Alloy F15 (Kovar) or Alloy 42 has electroplated thereon a base layer 14 of gold. The substrate 12 may be of any desired thickness, and typically is in the order of about 0.25 mm (about 0.01 inch). The thicknesses shown in the drawings Figs. 1 and 2 are not to scale, and are merely representative of the arrangement of the layer system.

A base layer 14 is electroplated over the substrate 12. The base layer 14 can be electroplated on one side only, or can be electroplated to cover the entire subs trace 12. Any suitable plating process can be used, and reference may be had to the referenced Patent 4,601,958, for example. The base layer 14 is, for example, a layer of gold; ocher materials may be used, e.g. platinum, silver, palladium, or their alloys. The important characteristic of the layer 14 is that it has an electromotive potential of the electromotive series of metals which is high with respect to the electromotive potential of the substrate 12. A single intermediate layer 16 is electroplated over the layer 14. This layer of nickel or a nickel based alloy, has to have the characteristic that it has an electromotive potential which is lower than that of layer 14, for example somewhat similar to that of the substrate 12. Preferably, it has an electromotive potential which is at the negative side of the electromotive series of metals. Nickel is frequently used and is one of the metals which meets the MIL-STD. The cover layer 18 preferably is of the same material as that of the base layer, although it need not be. The electroplated cover layer should have an electromotive potential which is, however, similar to that of the base layer 14. The materials should be so selected that the relative values of the electromotive potentials are such that the difference of potentials between the first and third layer of metal and the potential of the second layer is as large as possible. The greater this difference, the greater will be the corrosion resistance.

Fig. 2 illustrates a defect 22, which may be a pin hole for example of microscopic size. The dimensions of the substrate as well as of the respective layers are grossly exaggerated in order to better show the nature of the defect. The defect 22, as shown, extends to the base of the metal substrate . Neither nickel nor gold , electroplated over the substrat span or bridge over the defect; a typical defect which is not bridged is an alumina impurity, or other surface impurities.

Resistance to corrosion of the system 12, 14, 16, 18, in spite of a pin hole 22, is believed to be due to this effect: Plating the first layer 14 of gold having an Emf of 1.40 volts accelerates an ion from the substrate 12 to the level of the first or base layer of gold 14. However, the second or intermediate layer 16 of nickel having a negative Emf of 0.25 volts will tend to repel the ion which was attracted by the +1.40 volts of the gold layer. Since the third or outer or cover layer 18 of the gold has the same Emf as the base or first layer 14 of gold, there is no electrical potential between the two layers 14, 18 of gold. As a result of this state of electrical potentials, an iron ion will not diffuse past the first layer 14 of gold. The ion will become iron oxide, schematically shown at 20, and actually plug the defect channel so that further corrosion is effectively inhibited.

This possible mechanism for greatly reducing the rate of corrosion is borne out by the experimental fact that even though a very slight amount of corrosion may take place in the first twenty-four hours of exposure to a salt spray atmosphere, no further corrosion is observed after forty-eight hours and seventy-two hours of exposure to the salt spray atmosphere.

The overall usual gold plating thickness for a standard plated part is fifty microinches or about 1.27 micrometers. Since gold is by far the most expensive component of the plated part, it is desirable to achieve the desired corrosion resistance without exceeding the fifty microinch (1.27 micrometers) dimension. In practice it has been found that excellent results are achieved by making the first layer 14 of gold about twenty-five microinches or about 0.64 micrometer thick, the second layer 16 of nickel about one hundred and fifty microinches (about 3.82 micrometers) thick, and the third outer layer 18 of gold about twenty-five micro inches (about 0.64 micrometer) thick. The outer layer 18 of gold 18 may be thicker than the base layer 14, for example layer 18 can be about 50 microinches (1.27 micrometers) thick; the base layer 14 can be 25 microinches (0.64 micrometer) thick. Although excellent results are obtained with this distribution of thicknesses, the first layer 14 of gold may vary from ten to forty microinches (about 0.25 to 1 micrometer), the second layer 16 of nickel from fifty to three hundred and fifty microinches (about 1.27 to 8.9 micrometers), and the outer layer 18 of gold from ten to two hundred and twenty five microinches (about 0.25 to 5.71 micrometers).

Although the example of plating with gold and nickel is given in the preceding situation, the same principle of plating with three layers of metal having the desired electromotive potentials can be used to significantly reduce corrosion in electroplated systems. This principle states that the first and third layers 14, 18 of preferably the same metal must have an Emf high at the positive end of the electromotive series of metals and that the second layer 16 of the three layers must have an Emf substantially closer to that of the substrate 12, e.g. to iron and preferably at the negative side of the electromotive series of metals. Examples of metals that may be used as first and third layers are gold (Emf of +1.4V), platinum (Emf of +1.2V) and silver (+0.8V). Examples of metals that may be used as the second layer are nickel (Emf of -0.25V) and a nickel based alloy. The greater the potential difference between the electrode potential of the first and third layer with respect to the electrode potential of the second layer, the greater will be the corrosion resistance.

In my prior Patent 4,601,958, a system was described in which an additional nickel layer was placed between the substrate 12 and the first gold layer 14. In accordance with the present invention, and upon a rethinking and restudy and experimentation with electroplating, it was concluded that the first layer of nickel on the substrate 12 was not needed to obtain the low corrosion characteristics. In fact, Alloy 42 as well as Kovar contain nickel, and placing an outer electroplated nickel layer on the nickel containing substrate 12 did very little in modifying the electromotive force relationships at the substrate which would be "seen" by the next layer of gold. Accordingly, experiments were carried out with a three-layer system in accordance with the present invention, and it was found that effectively zero corrosion could be obtained. Surprisingly, the system had the additional advantage of being substantially more resistant to blistering under high temperature tests since the adhesion of gold, for example, to the substrate 12 is better than that of nickel on the substrate 12.

The thicknesses of the respective layers 14, 16, 18 are not critical. Preferably, the layers 14, 18 should be about 10 micro inches (0.25 micrometer); below a thickness of about 10 micro inches (0.25 micrometer), the reliability and resistance to pin holes, as well as uniformity of quality, is difficult to maintain. Increasing the thickness of the gold layers beyond 25 microinches (about 0.64 micrometer), however, does not appear to significantly improve the integrity of the composite layer and may only lead to increased use of an expensive material. For some particularly critical applications, a base layer 14 of gold of about 25 microinches (O.64 micrometer) and a top, or outer cover layer 18 of gold of about 50 microinches (1.27 micrometers) is desirable. The intermediate nickel layer 16 can be between about 100 (2.5 micrometer) to 250 microinches (6.4 micrometers), preferably about 150 microinches (3.82 micrometer) thick.

The measurements above referred to are usually made as the minimum thicknesses. When electroplating layers on metal plates or substrates, a "dog-bone" effect takes place in that the regions of plating closer to the edges of the substrate will be thicker than those in the center portion. The dimensions referred to herein relate to the minimum dimensions across the plated articles.

## Claims

1. A plated metal part comprising
a substrate (12) of an iron-nickel alloy where the major constituent is iron and which is corrodable in a corrosive or salt atmosphere environment; and
only three layers electroplated on said substrate, said only three layers comprising
a base layer (14) electroplated on the substrate and comprising a metal from the group consisting: of
gold, platinum, silver, palladium, or their alloys;
a single intermediate layer (16) electroplated on the base layer (14) and comprising nickel or a nickel-based alloy; and
a cover layer (18) electroplated on the intermediate layer (16) and comprising a metal selected from the group consisting of: gold, platinum, silver, palladium, or their alloys.

2. The article of claim 1, wherein the base layer (14) and the cover layer (18), each, comprise gold.

3. The article of claim 2, wherein the gold layers have a thickness of between 0.25 µm to 1.27 µm,preferably between 0.64 µm to 1 µm; and the intermediate layer (16) has a thickness of between 1.27 µm to 8.9 µm, preferably about 3.82 µm.

4. The article of claim 1, wherein the substrate (12) comprises an iron based alloy which includes nickel as constituant component which substrate material is selected from the group consisting of alloy F15 or alloy 42.

5. The article of claim 1, wherein the cover layer (18) is thicker than the base layer (14).

6. The article according to claim 5, wherein the cover layer (18) has a thickness of about 1.27 µm gold and the base layer (14) has a thickness of 0,64 µm gold.

7. The article of claim 1, wherein the cover layer (18) and the base layer (14) are of about 0,64 µm thick gold.

8. The article according to any of the preceding claims, for use as a semiconductor package sealing cover.

9. A process of enhancing the corrosion resistance of a substrate (12) of an iron-nickel alloy where the major constituent is iron
said process comprising the steps of:
electroplating only three layers on said metal substrate, and
wherein the steps of electroplating said only three layers include electroplating, on said substrate (12) a first or base layer (14) which comprises a metal selected from the group consisting of: gold, platinum, silver, palladium, or their alloys;
electroplating, on said base layer (14) a single intermediate layer (16) which comprises a nickel or nickel-based alloy; and
electroplating on said single intermediate layer (16) a cover layer (18) which comprises a metal selected from the group consisting of: gold, platinum, silver, palladium, or their alloys.

10. The process of claim 9, wherein the base layer (14) and the cover layer (18) have a thickness of between 0.25 µm to 1.27 µm, preferably between 0.64 µm and 1 µm and desirably are of gold; and the intermediate layer has a thickness between 1.27 µm to 8.9 µm, preferably 3,82 µm and preferably of nickel or nickel based alloy.

## Patentansprüche

1. Beschichteter Metallgegenstand mit
einem Substrat (12) aus einer Eisen-Nickel-Legierung, bei der der Hauptbestandteil Eisen ist und die in einer korrosiven oder Salzatmosphärenumgebung korrodierbar ist, wobei das Substrat nur mit drei Schichten elektrobeschichtet ist und diese lediglich drei Schichten umfassen:
eine Grundschicht (14), mit der das Substrat elektrobeschichtet ist und die von einem Metall aus der Gruppe, die Gold, Platin, Silber, Palladium oder ihre Legierungen umfaßt, gebildet ist;
eine einzige Zwischenschicht (16), mit der die Grundschicht (14) elektrobeschichtet ist und die von Nikkel oder einer auf Nickel basierenden Legierung gebildet ist; und
einer Deckschicht (18), mit der die Zwischenschicht (16) elektrobeschichtet ist und die von einem Metall gebildet ist, das aus der Gruppe, die Gold, Platin, Silber, Palladium oder ihre Legierungen umfaßt, ausgewählt ist.

2. Gegenstand nach Anspruch 1, bei dem die Grundschicht (14) und die Deckschicht (18) jeweils Gold aufweisen.

3. Gegenstand nach Anspruch 2, bei dem die Goldschichten eine Dicke zwischen 0,25 und 1,27 µm, vorzugsweise zwischen 0,64 µm und 1 µm aufweisen; und bei dem die Zwischenschicht (16) eine Dicke zwischen 1,27 und 8,9 µm, vorzugsweise um 3,82 µm aufweisen.

4. Gegenstand nach Anspruch 1, bei dem das Substrat (12) von einer auf Eisen basierenden Legierung gebildet ist, die als Bestandteil Nickel enthält, wobei das Substratmaterial aus der Alloy F15 oder Alloy 42 umfassenden Gruppe ausgewählt ist.

5. Gegenstand nach Anspruch 1, bei dem die Deckschicht (18) dicker als die Grundschicht (14) ist.

6. Gegenstand nach Anspruch 5, bei dem die Deckschicht (18) Gold mit einer Dicke von 1,27 µm und die Grundschicht (14) Gold mit einer Dicke von 0,64 µm ist.

7. Gegenstand nach Anspruch 1, bei dem die Deckschicht (18) und die Grundschicht (14) Gold mit einer Dicke von etwa 0,64 µm sind.

8. Gegenstand nach einem der vorhergehenden Ansprüche zur Verwendung als Halbleitergehäuse-Abdeckhaube.

9. Verfahren zur Verbesserung der Korrosionsfestigkeit eines Substrates (12) aus einer Eisen-Nickel-Legierung, deren Hauptbestandteil Eisen ist, wobei das Verfahren die Schritte umfaßt:
es wird das Metallsubstrat mit lediglich drei Schichten elektrobeschichtet, wobei die Schritte des Elektrobeschichtens mit den lediglich drei Schritten beinhalten, es wird das Substrat (12) mit einer ersten oder Grundschicht (14) elektrobeschichtet, die aus einem Metall besteht, das aus einer Gold, Platin, Silber, Palladium oder ihre Legierungen umfassenden Gruppe ausgewählt ist;
es wird die Grundschicht (14) mit einer einzigen Zwischenschicht (16) elektrobeschichtet, die aus Nickel oder einer auf Nickel basierenden Legierung gebildet ist, und
es wird die einzige Zwischenschichtet(16) mit einer Deckschicht (18) elektrobeschichtet, die von einem Metall das aus einer Gold, Platin, Silber, Palladium oder ihre Legierungen umfassenden Gruppe ausgewählt ist.

10. Verfahren nach Anspruch 9, bei dem die Grundschicht (14) und die Deckschicht (18) eine Dicke zwischen 0,25 µm und 1,27 µm, vorzugsweise zwischen 0,64 µm und 1 µm aufweist und vorzugsweise aus Gold besteht; und bei dem die Zwischenschicht eine Dicke zwischen 1,27 µm und 8,9 µm, vorzugsweise 3,82 µm aufweist und vorzugsweise aus Nickel oder einer auf Nickel basierenden Legierung besteht.

## Revendications

1. Composant métallique plagué comprenant :
- un substrat (12) en alliage fer-nickel dans lequel le constituant principal est le fer et qui peut se corroder dans une atmosphère salée ou corrosive, et
- seulement trois couches déposées par électrolyse sur ledit substrat, ces trois couches comprenant :
une couche de base (14) déposée par électrolyse sur le substrat et contenant un métal choisi dans le groupe formé par l'or, le platine, l'argent, le palladium et leurs alliages,
une couche intermédiaire (16) unique, déposée par électrolyse sur la couche de base (14) et contenant du nickel ou un alliage à base de nickel, et
une couche de recouvrement (18) déposée par électrolyse sur la couche intermédiaire (16) et contenant un métal choisi dans le groupe formé par l'or, le platine, l'argent, le palladium et leurs alliages.

2. Objet selon la revendication 1, dans lequel la couche de base (14) et la couche de recouvrement (18) contiennent toutes deux de l'or.

3. Objet selon la revendication 2, dans lequel les couches d'or ont une épaisseur comprise entre 0,25 µm et 1,27 µm, et de préférence entre 0,64 µm et 1 µm, et la couche intermédiaire (16) a une épaisseur comprise entre 1,27 µm et 8,9 µm et de préférence d'environ 3,82 µm.

4. Objet selon la revendication 1, dans lequel le substrat (12) contient un alliage à base de fer qui inclut du nickel comme composant constituant, le matériau du substrat étant choisi dans le groupe formé par l'alliage F15 et l'alliage 42.

5. Objet selon la revendication 1, dans lequel la couche de recouvrement (18) est plus épaisse que la couche de base (14).

6. Objet selon la revendication 5, dans lequel la couche de recouvrement (18) a une épaisseur d'environ 1,27 µm d'or et la couche de base (14) a une épaisseur de 0,64 µm d'or.

7. Objet selon la revendication 1, dans lequel la couche de recouvrement (18) et la couche de base (14) ont une épaisseur d'or d'environ 0,64 µm.

8. Objet selon l'une quelconque des précédentes revendications destiné à être utilisé comme couvercle d'étanchéité d'un boitier de semi-conducteur.

9. Procédé d'amélioration de la résistance à la corrosion d'un substrat (12) en alliage fer-nickel dans lequel le constituant principal est du fer, ledit procédé comprenant l'étape consistant à déposer par électrolyse uniquement trois couches sur ledit substrat métallique et dans lequel l'étape de dépôt par électrolyse desdites trois couches inclut le dépôt par électrolyse, sur ledit substrat (12), d'une première couche (14) ou couche de base qui contient un métal choisi dans le groupe formé par l'or, le platine, l'argent, le palladium et leurs alliages, le dépôt par électrolyse, sur ladite couche de base (14), d'une couche intermédiaire (16) unique qui contient du nickel ou un alliage à base de nickel, et le dépôt par électrolyse sur ladite couche intermédiaire (16) unique d'une couche de recouvrement (18) qui contient un métal choisi dans le groupe formé par l'or, le platine, l'argent, le palladium et leurs alliages.

10. Procédé selon la revendication 9, dans lequel la couche de base (14) et la couche de recouvrement (18) ont une épaisseur comprise entre 0,25 µm et 1,27 µm, et de préférence entre 0,64 µm et 1 µm, et sont de préférence en or, et la couche intermédiaire a une épaisseur comprise entre 1,27 µm et 8,9 µm, de préférence de 3,82 µm et est de préférence du nickel ou un alliage à base de nickel.
